# EUROPEAN PATENT APPLICATION

(11) **EP 4 554 355 A1**
(43) Date of publication of application: **14.05.2025**
(21) Application number: 24195808.1
(22) Date of filing: 22.08.2024
(51) Int. Cl.: H10D 62/10, H10D 30/01, H10D 30/00, H10D 84/01, H10D 84/03, H10D 84/83, H10D 88/00

(54) **TRANSISTOR DEVICES HAVING GATE-CUTS, AND FABRICATION METHODS THEREOF**

(30) Priority: 08.11.2023 US 202363597287 P; 30.05.2024 US 202418678183
(71) Applicant: Samsung Electronics Co., Ltd, Suwon-si, Gyeonggi-do 16677 (KR)
(72) Inventor: YUN, Seungchan, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

Transistor devices (100) are provided. A transistor device (100) includes a substrate (110) and a transistor stack (101) on the substrate (110). The transistor stack (101) includes a lower transistor (Tb) and an upper transistor (Ta) that is on top of the lower transistor (Tb). Moreover, the transistor device (100) includes a gate-cut on the substrate (110), adjacent the transistor stack (101). The gate-cut has a first sloped sidewall and a second sloped sidewall that is opposite the first sloped sidewall. Related methods of forming transistor devices (100) are also provided.

## Description

### TECHNICAL FIELD

The present disclosure generally relates to the field of semiconductor devices and, more particularly, to devices having gate-cuts between transistor structures.

### BACKGROUND

The size of transistors in integrated circuit devices has continued to decrease to down-scale logic elements. This has resulted in the development of gate-all-around (GAA) structures such as multi-bridge channel field-effect transistors (MBCFETs^{™}) and nanosheet FETs (NSFETs). Moreover, as technology to increase transistor density has continued to develop, three-dimensional device structures, such as stacked transistors, are under consideration.

### SUMMARY

A transistor device may include a substrate and a transistor stack on the substrate. The transistor stack may include a lower transistor and an upper transistor that is on top of the lower transistor. Moreover, the transistor device may include a gate-cut on the substrate, adjacent the transistor stack. The gate-cut may have a first sloped sidewall and a second sloped sidewall that is opposite the first sloped sidewall. An upper portion of the second sloped sidewall may be adjacent, and may slope toward, the upper transistor.

A transistor device may include a substrate. The transistor device may include a first transistor stack and a second transistor stack that are spaced apart from each other in a lateral direction on the substrate. The first transistor stack and the second transistor stack may each include a lower transistor and an upper transistor that is on top of the lower transistor. Moreover, the transistor device may include a gate-cut that is between, in the lateral direction, the first transistor stack and the second transistor stack. The upper transistor may include a plurality of semiconductor channel layers. The gate-cut may extend higher, in a vertical direction, than an uppermost one of the plurality of semiconductor channel layers. The gate-cut may include a first sidewall that is concave and a second sidewall that is concave or convex.

A method of forming a transistor device may include forming a polysilicon layer on a plurality of semiconductor channel layers of a transistor. The method may include forming a gate-cut after forming the polysilicon layer. Forming the gate-cut may include forming an insulating layer on the polysilicon layer. The polysilicon layer may be a sacrificial spacer by which the gate-cut is spaced apart from the plurality of semiconductor channel layers. Moreover, the method may include forming source/drain regions on sidewalls of the plurality of semiconductor channel layers after forming the gate-cut.

### BRIEF DESCRIPTION OF THE DRAWINGS

FIG. 1A is a schematic block diagram of a transistor stack of a transistor device according to some embodiments herein.
FIG. 1B is an example cross-sectional view of the transistor device of FIG. 1A.
FIG. 1C is a schematic block diagram of a gate-cut that is between two transistor stacks of the transistor device of FIG. 1A.
FIGs. 1D, 1F, and 1G are example cross-sectional views of the gate-cut of FIG. 1C.
FIG. 1E is an enlarged view of the gate-cut of FIG. 1D.
FIGs. 2A-2AD are cross-sectional views illustrating operations of forming the transistor device of FIG. 1C.
FIG. 3 is a flowchart corresponding to the operations shown in FIGs. 2A-2AD.

### DETAILED DESCRIPTION

Pursuant to embodiments herein, transistor devices are provided that include self-aligned gate-cuts having sloped sidewalls. Each gate-cut may be formed on a sacrificial spacer that spaces the gate-cut apart from an adjacent transistor. Because the gate-cuts are adequately-spaced from adjacent transistors, they can address misalignment issues with respect to the transistors. In contrast, a conventional gate-cut may be misaligned such that it may damage an adjacent transistor. For example, the misaligned conventional gate-cut may be so close to the transistor that its formation (e.g., an etch operation/process for forming the gate-cut) may damage a channel layer, or other layer, of the transistor, or may affect the performance of the transistor.

In some embodiments, a transistor device may include stacked transistors having multi-bridge channels or nanosheets. As the pitch of a gate and the pitch of nanosheets or multi-bridge channels continue to down-scale, it may be difficult to implement a gate-cut separating adjacent stacked transistors. As an example, the space (e.g., lateral distance) between a gate-cut and a stacked transistor (e.g., a bottom portion of the stacked transistor, such as an active region thereof) may decrease as the pitch of nanosheets or multi-bridge channels of the stacked transistor is scaled down, thereby increasing the risk of damaging (e.g., recessing) the stacked transistor during formation of the gate-cut. According to embodiments herein, however, a self-align technique may be implemented to form the gate-cut with sufficient spacing from the stacked transistor to limit (e.g., prevent) damage to the stacked transistor.

Moreover, though stacked transistors may be susceptible to damage from gate-cut misalignment and are described in examples herein, embodiments herein are not limited to stacked transistors. For example, structures, features, and/or fabrication operations disclosed herein may be applied to FinFETs and other non-stacked FETs.

Example embodiments will be described in greater detail with reference to the attached figures.

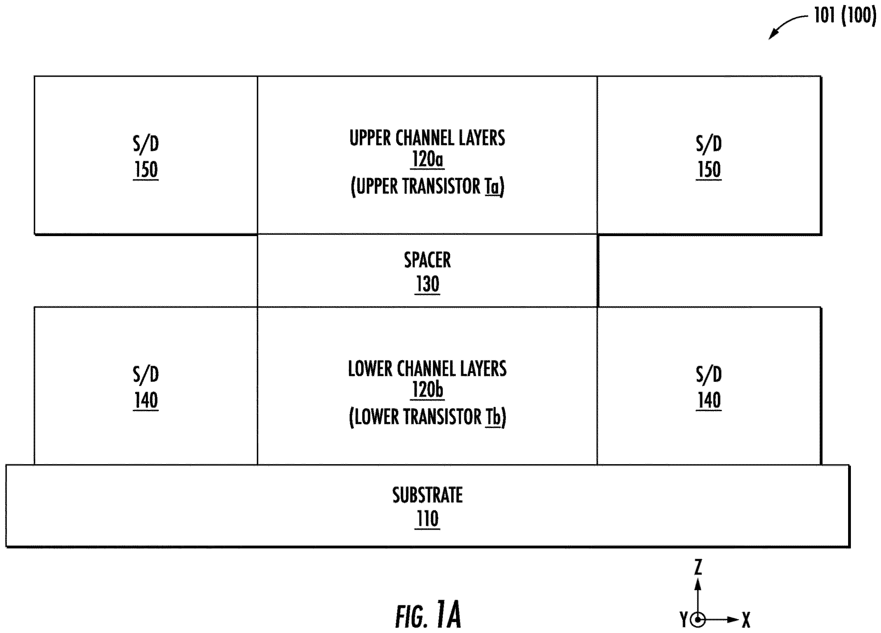

FIG. 1A is a schematic block diagram of a transistor stack 101 of a transistor device 100 according to some embodiments herein. The transistor stack 101 includes a lower transistor Tb having a stack of a plurality of lower semiconductor channel layers 120b and an upper transistor Ta having a stack of a plurality of upper semiconductor channel layers 120a. The channel layers 120a, 120b may comprise, for example, silicon and may be free of germanium and carbon. The lower transistor Tb is between, in a vertical direction Z, the upper transistor Ta and a substrate 110 (e.g., a silicon, or other semiconductor, substrate). Moreover, a middle dielectric isolation layer 130 may, in some embodiments, serve as a spacer between the lower and upper transistors Ta, Tb.

The lower channel layers 120b of the lower transistor Tb are between, in a first horizontal (i.e., lateral) direction X, a pair of lower source/drain (S/D) regions 140 that are electrically connected to the lower channel layers 120b. The first horizontal direction X and the vertical direction Z may be perpendicular to each other, and a second horizontal (i.e., lateral) direction Y may be perpendicular to each of the first horizontal direction X and the vertical direction Z. Each lower channel layer 120b may be implemented by, for example, a nanosheet or nanowire between the lower S/D regions 140. Likewise, the upper channel layers 120a of the upper transistor Ta may be between, in the first horizontal direction X, a pair of upper S/D regions 150 that are electrically connected to the upper channel layers 120a, and each upper channel layer 120a may be implemented by, for example, a nanosheet or nanowire between the upper S/D regions 150.

In some embodiments, the upper S/D regions 150 may include a different semiconductor material from that of the lower S/D regions 140. As an example, the upper S/D regions 150 may include silicon germanium, and the lower S/D regions 140 may include silicon carbide, or vice versa. In other embodiments, the upper S/D regions 150 may include the same semiconductor material as the lower S/D regions 140.

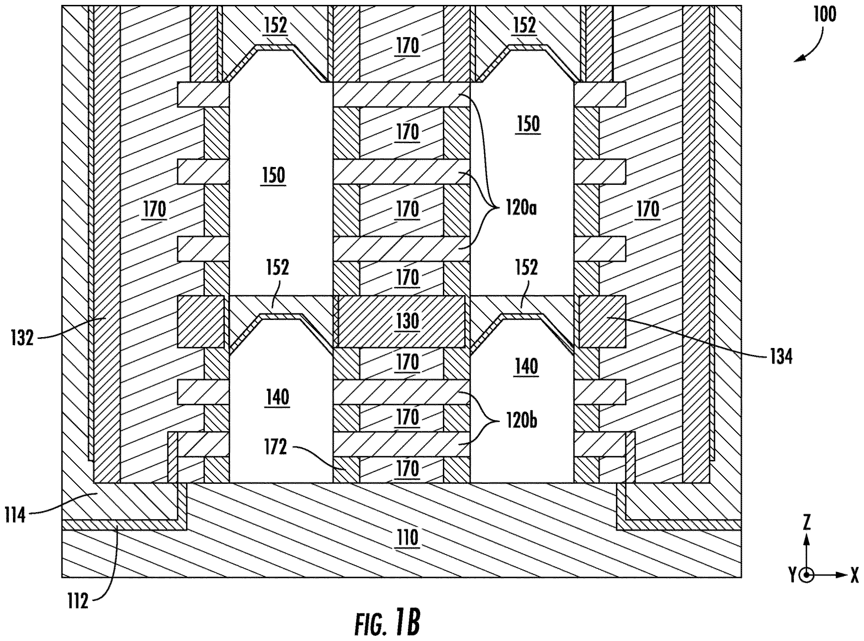

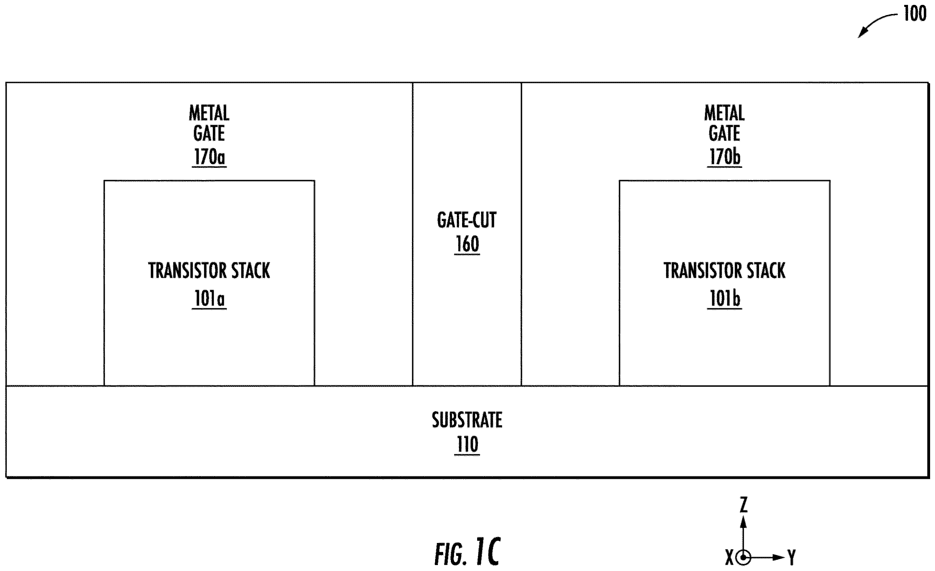

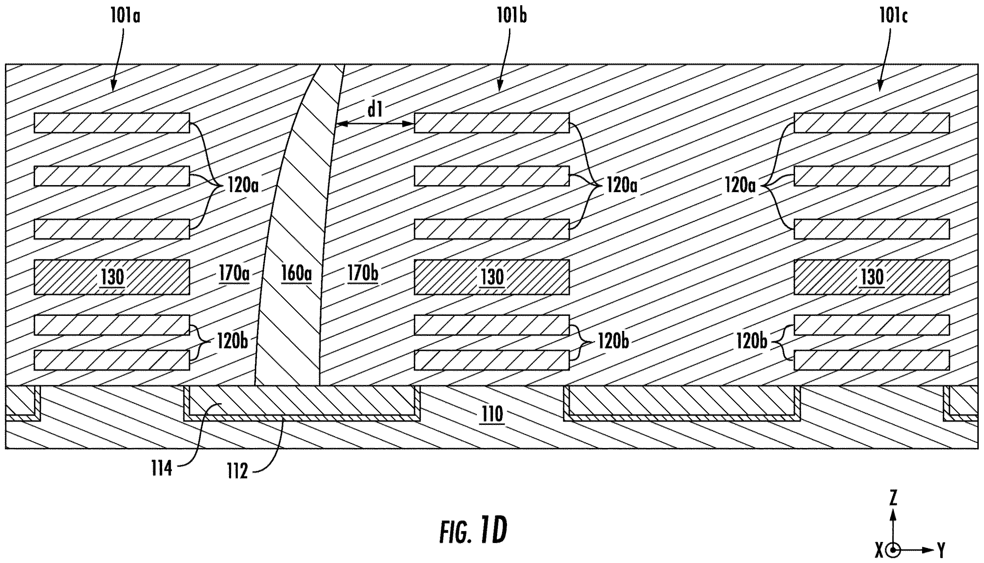

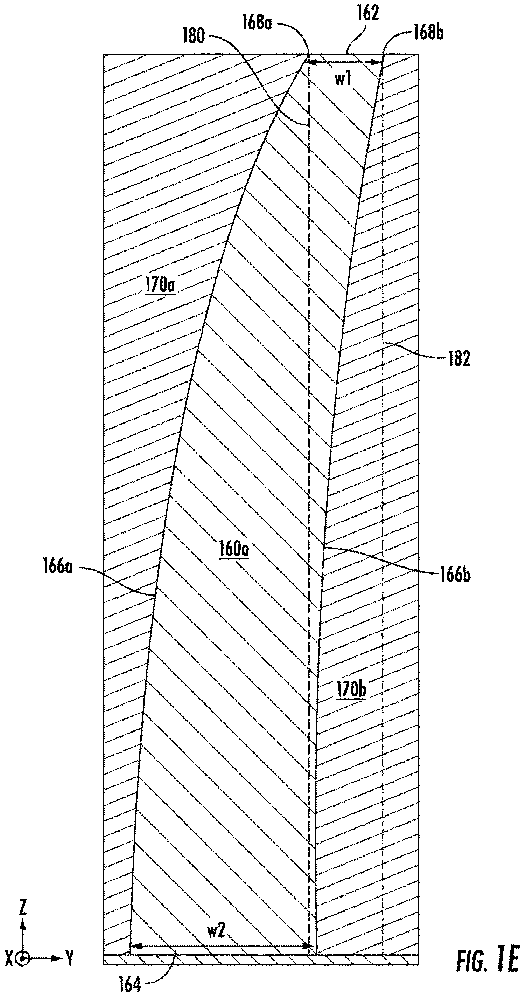

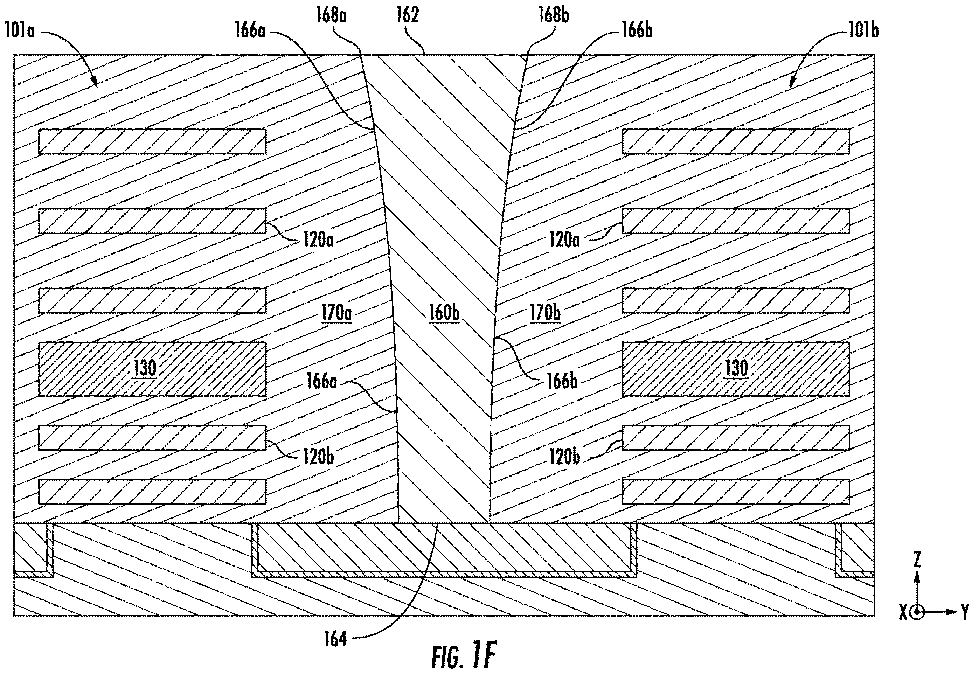

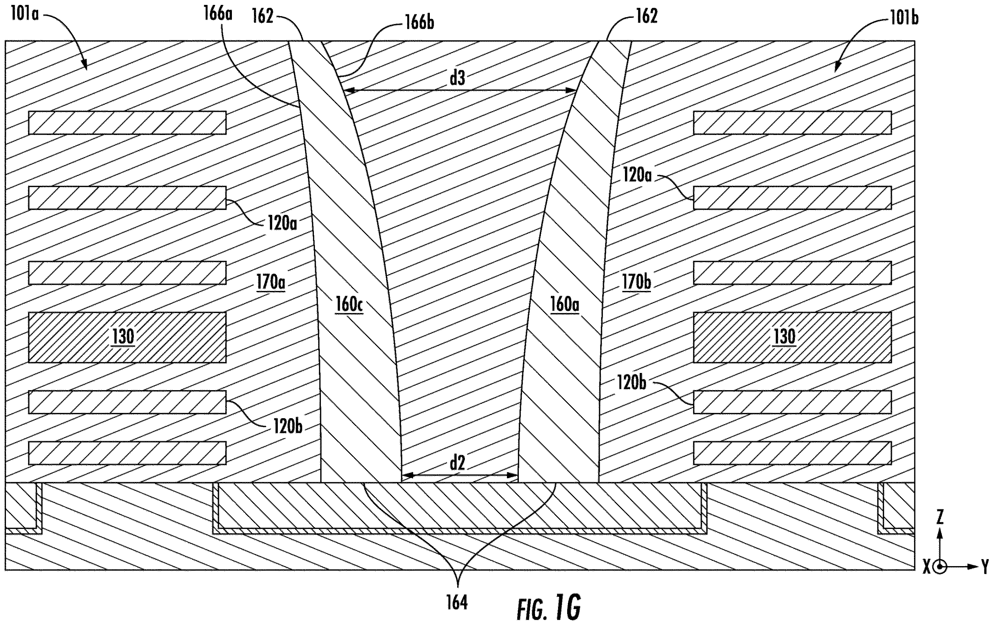

For simplicity of illustration, only one transistor stack 101 is shown in FIG. 1. According to some embodiments, however, the device 100 may include two, three, four, or more transistor stacks 101.

FIG. 1B is an example cross-sectional view of the transistor device 100. As shown in FIG. 1B, a metal gate 170 may be on the upper channel layers 120a of the upper transistor Ta of the transistor stack 101 (FIG. 1A), and on the lower channel layers 120b of the lower transistor Tb (FIG. 1A) of the transistor stack 101. The gate 170 may be spaced apart from the lower S/D regions 140 in the direction X by insulating spacers 172. The spacers 172 may be on sidewalls of the gate 170 and between, in the vertical direction Z, the lower channel layers 120b. Likewise, the gate 170 may be spaced apart from the upper S/D regions 150 in the direction X by spacers 172, which may be on sidewalls of the gate 170 and between, in the vertical direction Z, the upper channel layers 120a. In some embodiments, the spacers 172 may contact the lower S/D regions 140, the upper S/D regions 150, and sidewalls of the gate 170. Sidewalls of the lower channel layers 120b may contact the lower S/D regions 140, and sidewalls of the upper channel layers 120a may contact the upper S/D regions 150.

Moreover, the spacers 172 may comprise, for example, nitrogen (e.g., silicon nitride). The spacers 172 may also be referred to herein as "inner spacers," as they are situated between nanosheet/nanowire channels within a transistor.

The upper and lower transistors Ta, Tb may be different types of MOSFETs. For example, the upper and lower transistors Ta, Tb may be PMOS and NMOS transistors, respectively, or vice versa. As an example, PMOS and NMOS transistors may be provided by S/D regions comprising silicon germanium and silicon carbide, respectively. In some embodiments, the isolation layer 130 may be spacer that separates the lower semiconductor channel layers 120b of the lower transistor Tb from the upper semiconductor channel layers 120a of the upper transistor Ta. The isolation layer 130 may comprise, for example, silicon boron carbonitride (SiBCN).

For simplicity of illustration, a gate insulation layer is omitted from view in FIG. 1B. It will be understood, however, that a gate insulation layer may extend between each channel layer 120 and a metal gate 170. The gate insulation layer may wrap around each channel layer 120 and may be thinner than the isolation layer 130.

According to some embodiments, an insulating layer 112 may be in a recess of the substrate 110. An insulating layer 114 may also be in the recess, and may extend above the substrate 110 to, for example, a level of an uppermost surface of the gate 170. An insulating layer 152 may be between, in the vertical direction Z, the lower and upper S/D regions 140, 150. Moreover, the insulating layer 152 may be on an upper surface of each of the upper S/D regions 150. An insulating layer 132 may be between the gate 170 and a sidewall of the insulating layer 114, and an insulating layer 134 may be between the gate 170 and a sidewall of the insulating layer 152.

The insulating layers 132, 134 may comprise the same insulating material (e.g., SiBCN) as the isolation layer 130, and this insulating material may be different from an insulating material of the insulating layer 112 and different from an insulating material of the insulating layers 114, 152. In some embodiments, the insulating layer 112 may comprise a different insulating material from that of the insulating layers 114, 152. As an example, the insulating layer 112 may comprise a nitride (e.g., silicon nitride), and the insulating layers 114, 152 may each comprise an oxide (e.g., silicon oxide).

FIG. 1C is a schematic block diagram of a gate-cut 160 that is between, in the direction Y, two transistor stacks 101a, 101b of the transistor device 100. The gate-cut 160 is on the substrate 110, and is adjacent each of the transistor stacks 101a, 101b. As used herein with respect to the gate-cut 160 and the transistor stacks 101a, 101b that are on opposite sides of the gate-cut 160, the term "adjacent" means that no other transistor stack 101 intervenes between the gate-cut 160 and the transistor stacks 101a, 101b. Moreover, as used herein with respect to a sidewall of the gate-cut 160 and one of the transistor stacks 101a, 101b, the term "adjacent" means that the sidewall is closer to the one of the transistor stacks 101a, 101b than to the other of the transistor stacks 101a, 101b.

The transistor stack 101a is the transistor stack 101 of FIG. 1A, and is labelled as "101a" in FIG. 1C to differentiate it from the transistor stack 101b. As shown in FIG. 1C, a first metal gate 170a is on the transistor stack 101a, and a second metal gate 170b is on the transistor stack 101b. The first metal gate 170a is the gate 170 of FIG. 1B, and is labelled as "170a" in FIG. 1C to differentiate it from the gate 170b. The gate-cut 160 comprises an insulating material (e.g., silicon nitride) that electrically isolates the first metal gate 170a from the second metal gate 170b.

FIGs. 1D, 1F, and 1G are example cross-sectional views of the gate-cut 160 of FIG. 1C, and FIG. 1E is an enlarged view of the gate-cut of FIG. 1D. As shown in FIG. 1D, the gate-cut 160 may be a gate-cut 160a that separates the first metal gate 170a from the second metal gate 170b, where an upper portion of the gate-cut 160a is closer, in the direction Y, to the transistor stack 101b than to the transistor stack 101a. For example, an uppermost one of the upper channel layers 120a in the transistor stack 101b is spaced apart from an upper portion of the gate-cut 160a by a distance d1 (in the direction Y), which may be the shortest distance between the gate-cut 160a and either of the transistor stacks 101a, 101b. The upper portion of the gate-cut 160a is angled (e.g., curved) toward the transistor stack 101b and away from the transistor stack 101a.

The transistor device 100 (FIG. 1C) may include more than two transistor stacks 101. For example, the transistor stack 101b may be between the transistor stack 101a and a transistor stack 101c. No other transistor stack 101, however, is between the transistor stacks 101a, 101b. Accordingly, no transistor stack 101 is between (in the direction Y) the gate-cut 160a and the transistor stack 101a, or between the gate-cut 160a and the transistor stack 101b. Moreover, though FIG. 1D shows an example in which no gate-cut 160 is between the transistor stacks 101b, 101c, the transistor device 100 may, in some embodiments, include a gate-cut 160 between the transistor stacks 101b, 101c. For simplicity of illustration, the transistor stack 101c is omitted from view in FIGs. 1C, 1F, and 1G.

As shown in FIG. 1E, the gate-cut 160a has a first sloped sidewall 166a and a second sloped sidewall 166b that is opposite the sloped sidewall 166a. The sloped sidewall 166b is spaced apart from the uppermost one of the upper channel layers 120a (FIG. 1D) in the transistor stack 101b by the distance d1 (FIG. 1D). The gate-cut 160a is asymmetrical with respect to a vertical axis, as the sloped sidewalls 166a, 166b both slope toward the uppermost one of the upper channel layers 120a in the transistor stack 101b and away from the uppermost one of the upper channel layers 120a in the transistor stack 101a (FIG. 1D).

In some embodiments, the sloped sidewalls 166a, 166b may be curved sidewalls having upper portions that curve toward the transistor stack 101b and away from the transistor stack 101a, as height increases in the vertical direction Z. The sloped sidewall 166a is a convex surface of the gate-cut 160a, and the sloped sidewall 166b is a concave surface of the gate-cut 160a. In other embodiments, at least one of the sloped sidewalls 166a, 166b may be a diagonal sidewall having an upper portion that is angled (e.g., tilted) toward the transistor stack 101b and away from the transistor stack 101a. The diagonal sidewall has a constant slope and is neither parallel nor perpendicular to the vertical direction Z, but rather may form an acute angle (e.g., between 5 degrees and 35 degrees) with the vertical direction Z. In contrast, the slope of a curved sidewall varies along the curve.

The upper portion of the gate-cut 160a is narrower than a lower portion of the gate-cut 160a. For example, the upper portion may comprise an uppermost surface 162 that is narrower than a lowermost surface 164 of the lower portion. The uppermost surface 162 may be coplanar with uppermost surfaces of the gates 170a, 170b, and thus may be higher (in the vertical direction Z) than an uppermost one of the channel layers 120a in the transistor stack 101b. In some embodiments, a width w1 (in the direction Y) of the uppermost surface 162 may be less than half of a width w2 (in the direction Y) of the lowermost surface 164. Moreover, the width of the gate-cut 160a may monotonically narrow with increased height in the vertical direction Z. Accordingly, the gate-cut 160a may never widen as the height increases from the lowermost surface 164 to the uppermost surface 162.

Opposite ends of the uppermost surface 162 are defined by an uppermost point 168a of the sloped sidewall 166a and an uppermost point 168b of the sloped sidewall 166b. Due to the slope of the upper portion of the gate-cut 160a toward the transistor stack 101b, the uppermost point 168b may not vertically overlap a lower portion of the gate-cut 160a. Accordingly, a vertical axis 182 that passes through the uppermost point 168b does not pass through the lowermost surface 164, but rather passes through the gate 170b.

In contrast with the uppermost point 168b, the uppermost point 168a may, in some embodiments, vertically overlap the lower portion of the gate-cut 160a, such that a vertical axis 180 passes through pass through both the uppermost point 168a and the lowermost surface 164, though the vertical axis 180 may be closer (in the direction Y) to a lowermost point of the sloped sidewall 166b than to a lowermost point of the sloped sidewall 166a. In other embodiments, the uppermost points 168a, 168b may both vertically overlap the gate 170b rather than the lower portion of the gate-cut 160a.

As shown in FIG. 1F, a gate-cut 160 is not limited to the asymmetrical shape that is shown in FIG. 1E. Rather, a gate-cut 160 may be a gate-cut 160b that is symmetrical with respect to a vertical axis (e.g., a vertical axis that passes through a center point of an uppermost surface 162 of the gate-cut 160b and a center point of a lowermost surface 164 of the gate-cut 160b). Moreover, an upper portion of the gate-cut 160b may be wider than a lower portion of the gate-cut 160b. For example, sloped sidewalls 166a, 166b of the gate-cut 160b may both be concave surfaces of the gate-cut 160b. The sloped sidewalls 166a, 166b may slope away from each other as they increase in height in the vertical direction Z. Accordingly, as the sloped sidewall 166a increases in height, it may curve toward the transistor stack 101a and away from the transistor stack 101b. Likewise, as the sloped sidewall 166b increases in height, it may curve toward the transistor stack 101b and away from the transistor stack 101a.

As shown in FIG. 1G, multiple gate-cuts 160 may intervene between the pair of transistor stacks 101a, 101b. For example, in addition to the gate-cut 160a that is shown in FIG. 1D, another gate-cut 160c may be between, in the direction Y, the transistor stacks 101a, 101b. The gate-cuts 160a, 160c are separate from (and thus do not contact) each other. The gate-cut 160c may be closer to the transistor stack 101a, and the gate-cut 160a may be closer to the transistor stack 101b. As with the gate-cut 160a, an upper portion of the gate-cut 160c may be narrower (in the direction Y) than a lower portion of the gate-cut 160c. Moreover, as height increases in the vertical direction Z, an upper portion of the gate-cut 160c may slope away from an upper portion of the gate-cut 160a. Accordingly, the lower portion of the gate-cut 160a and the lower portion of the gate-cut 160c may be spaced apart from each other by a distance d2 (in the direction Y) that is shorter than a distance d3 (in the direction Y) by which the upper portion of the gate-cut 160a is spaced apart from the upper portion of the gate-cut 160c. In some embodiments, the gate-cuts 160a, 160c may be mirror images of each other with respect to a vertical axis.

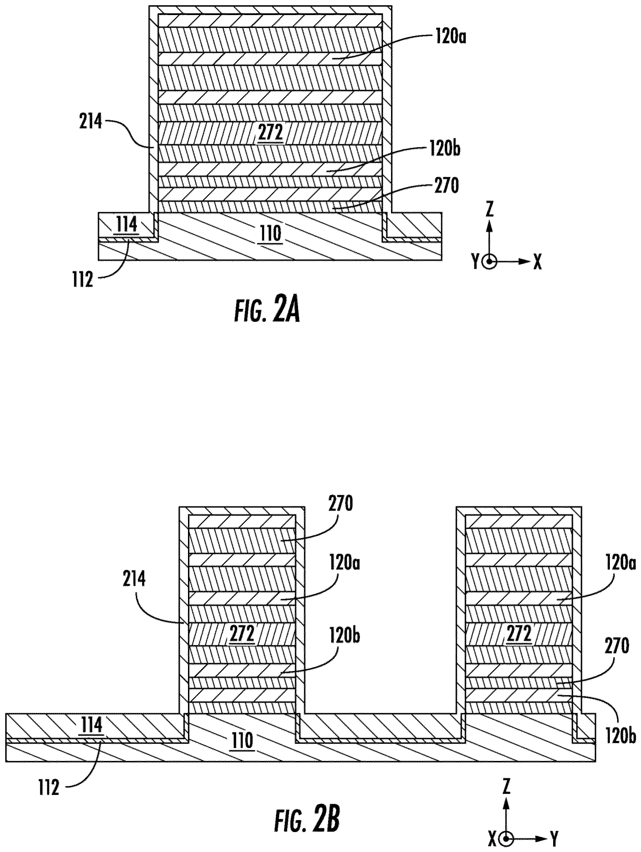

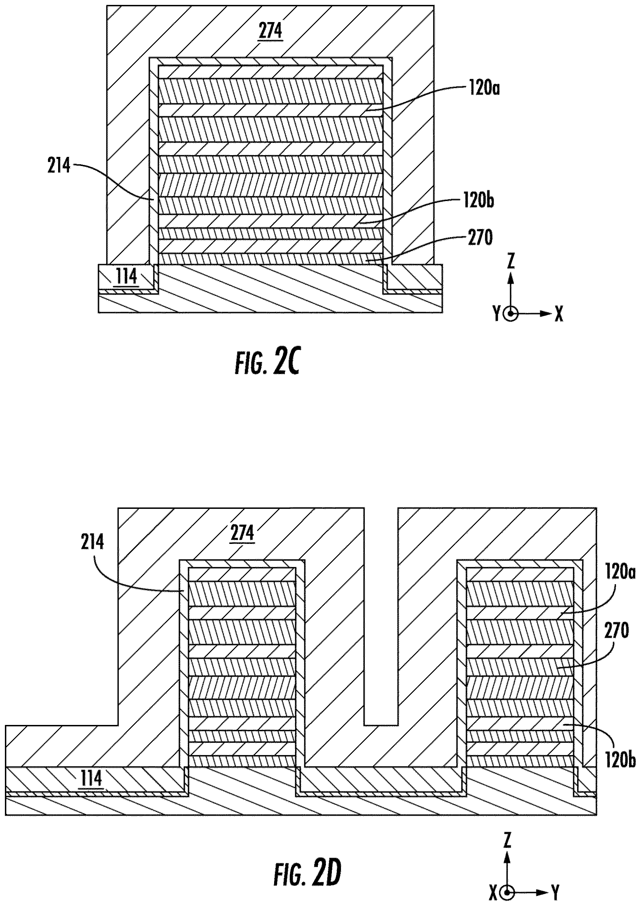

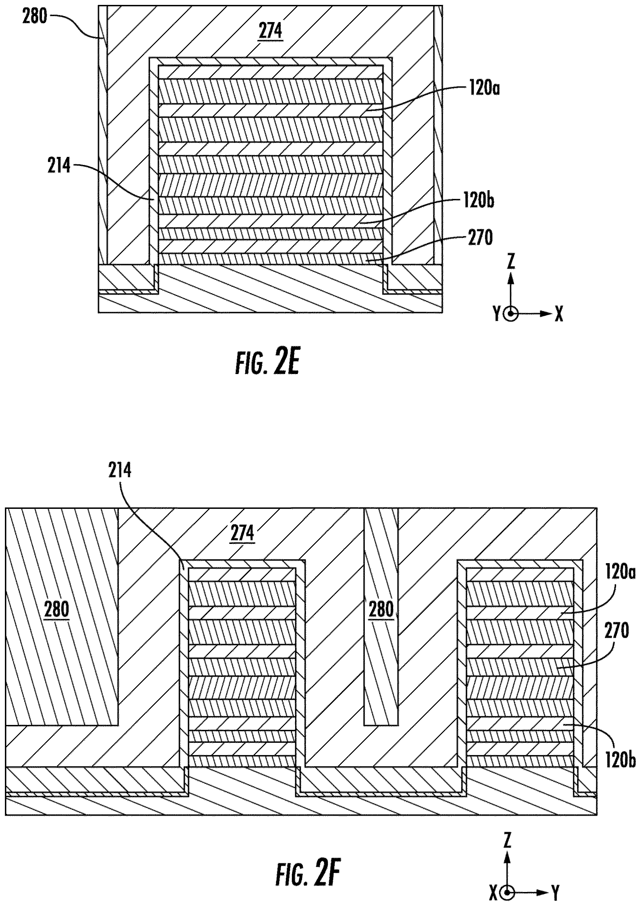

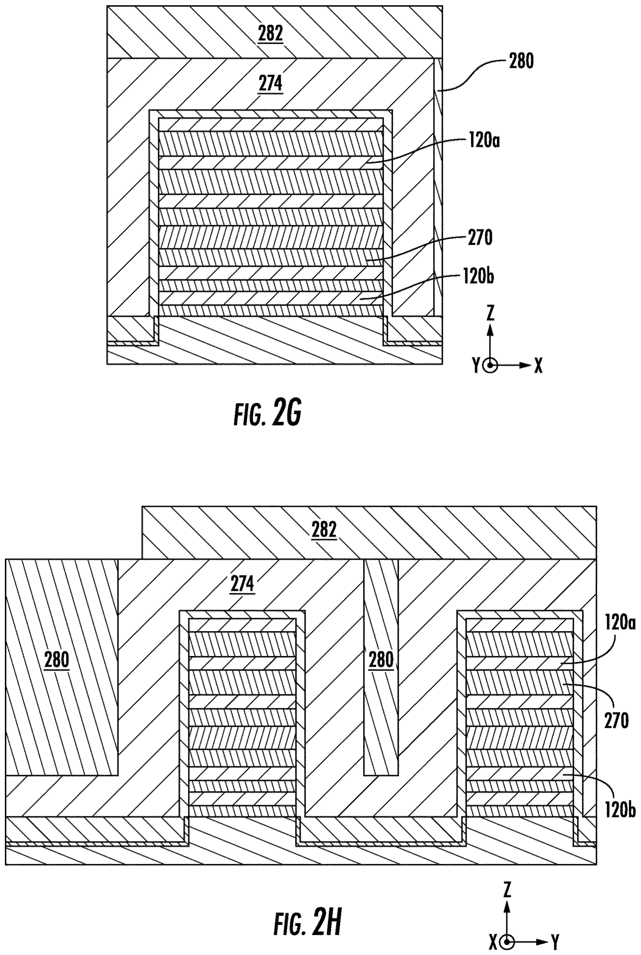

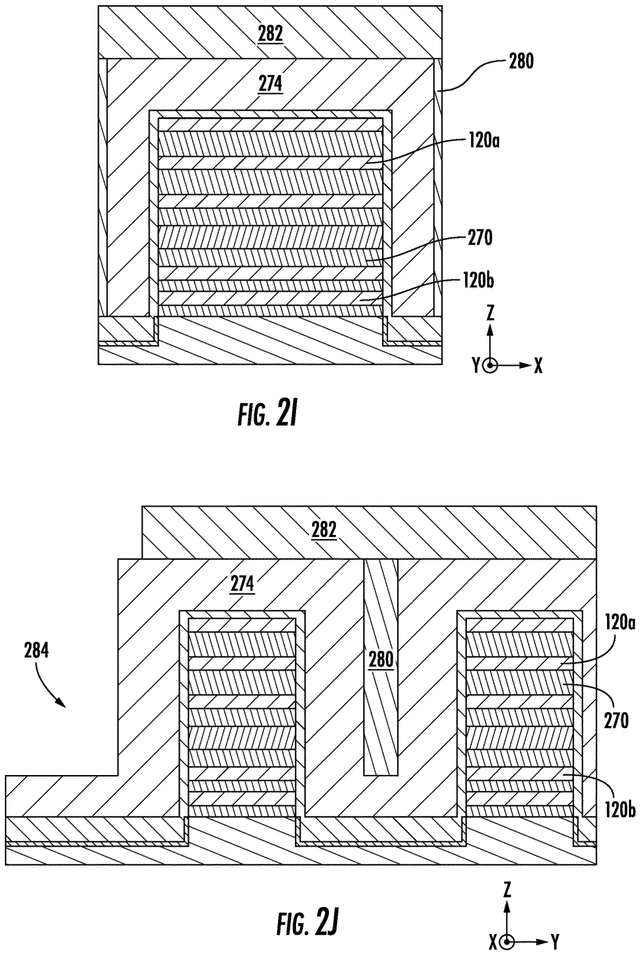

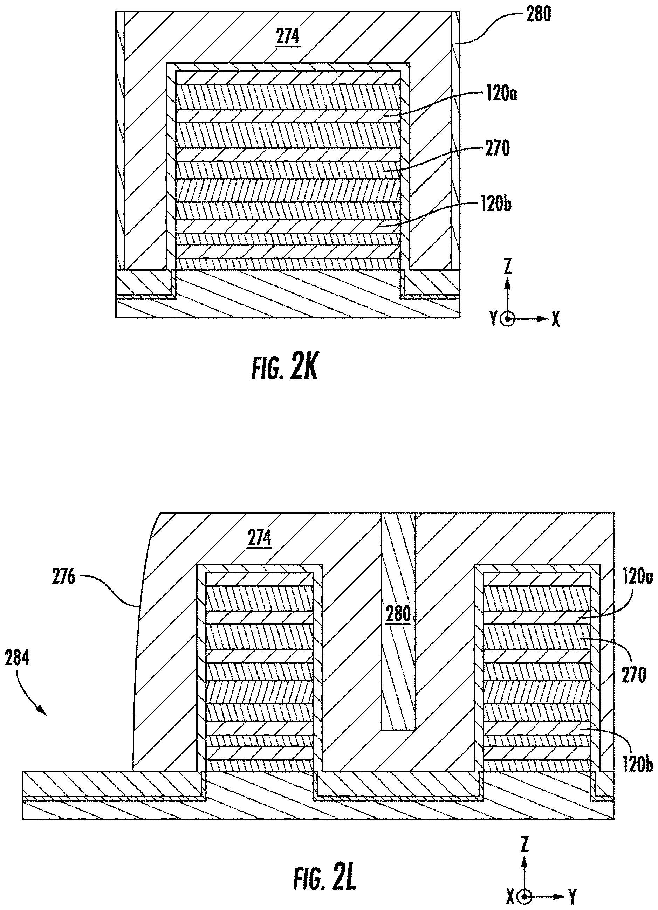

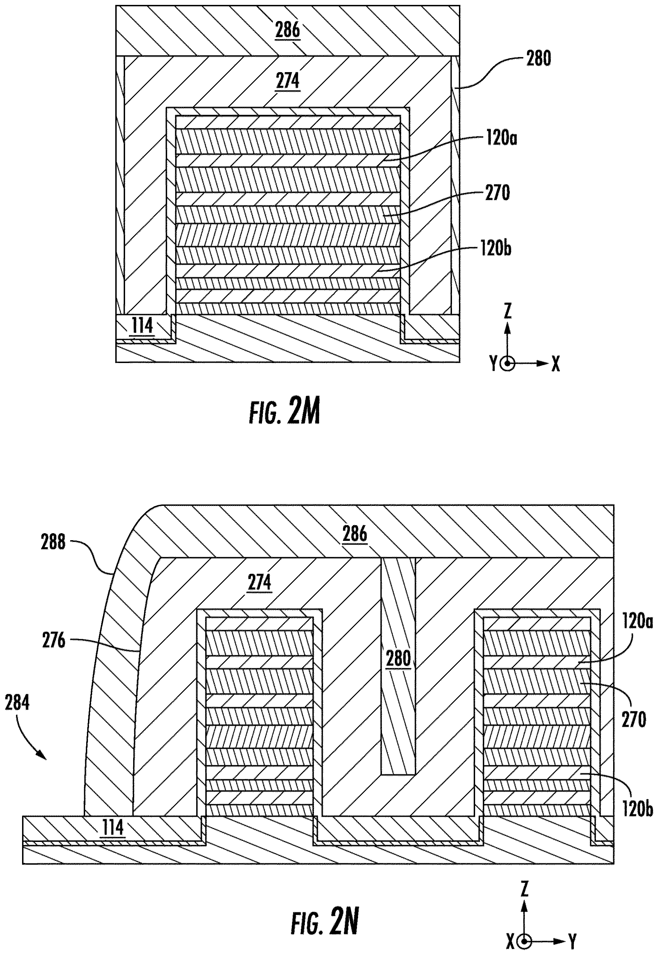

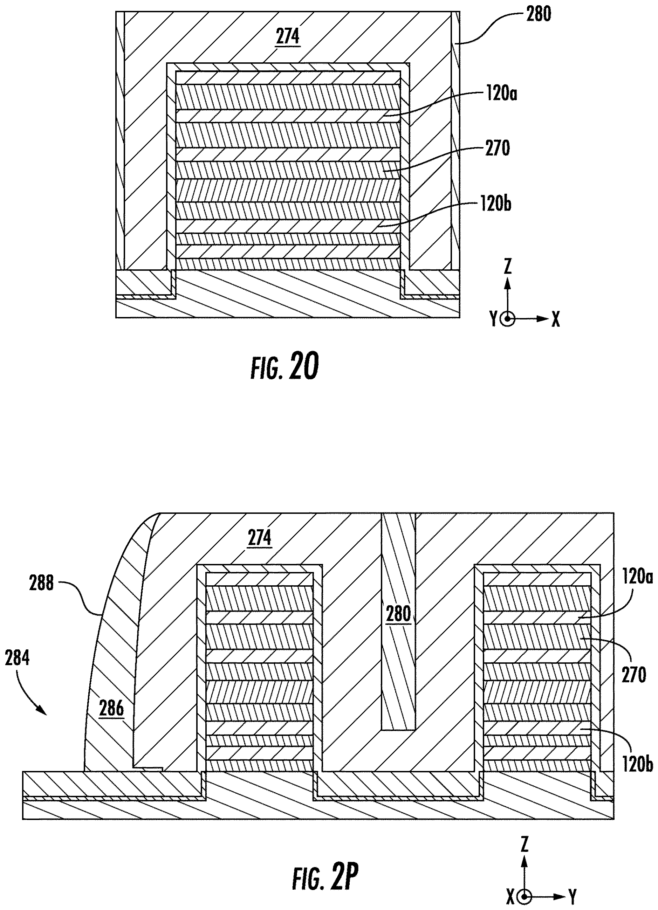

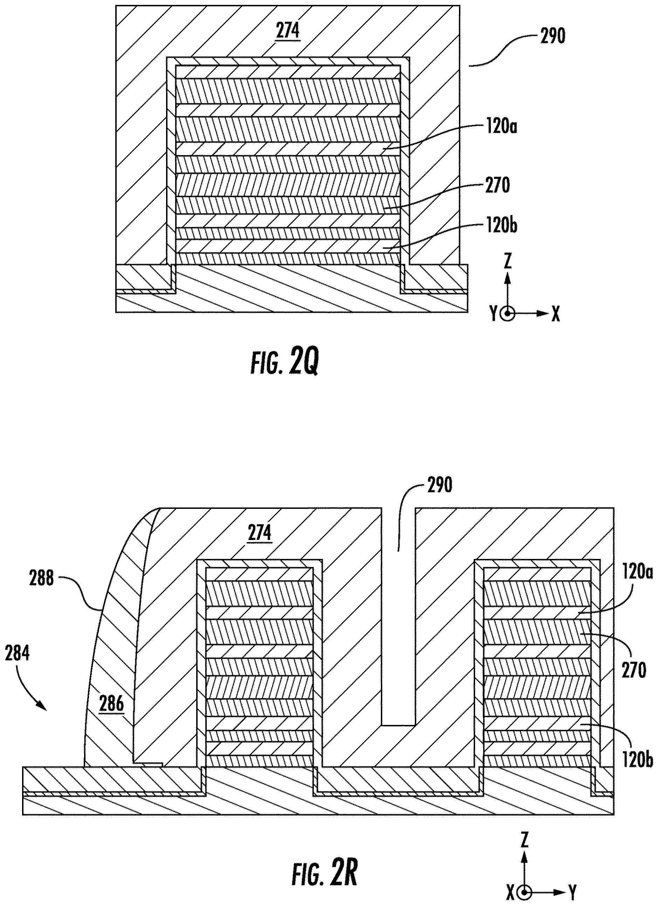

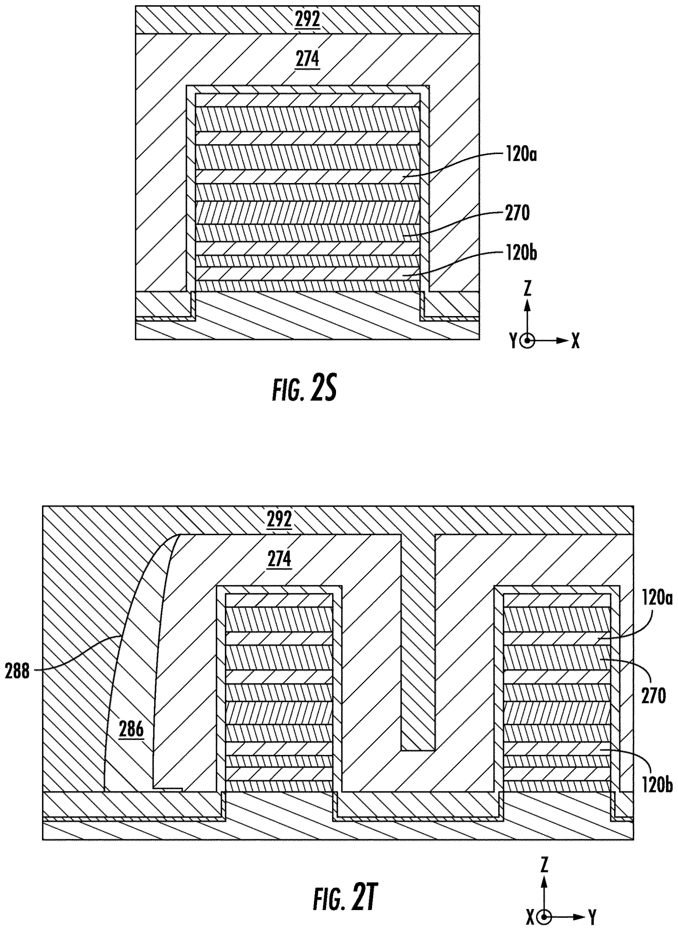

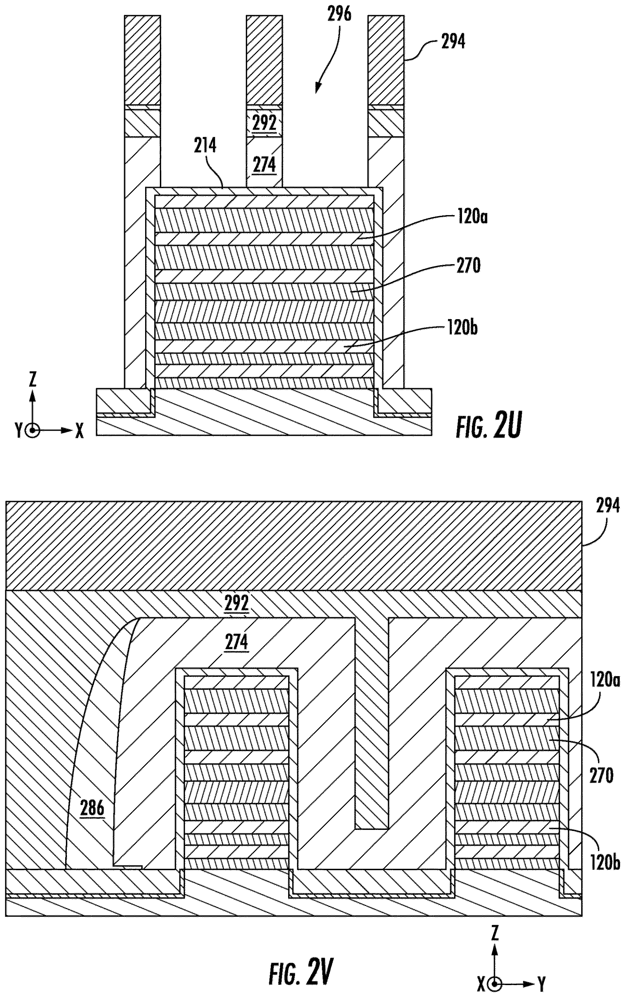

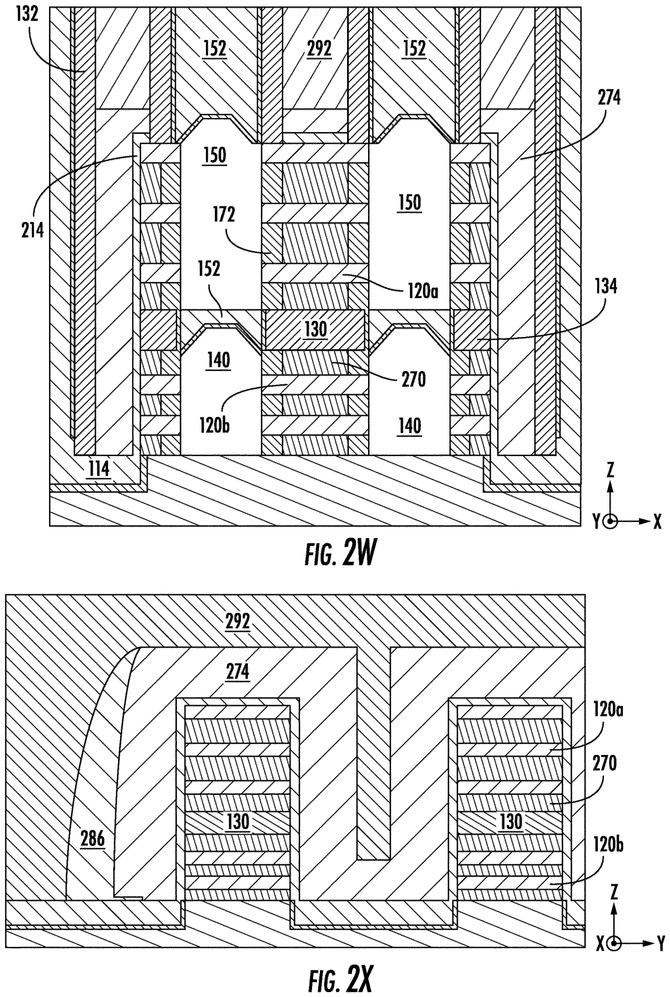

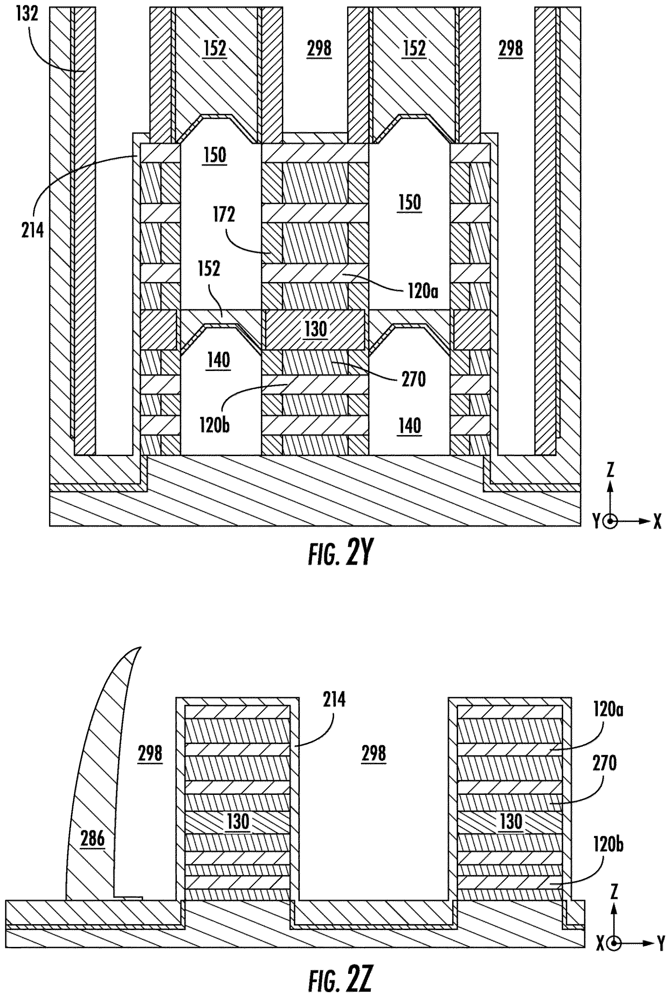

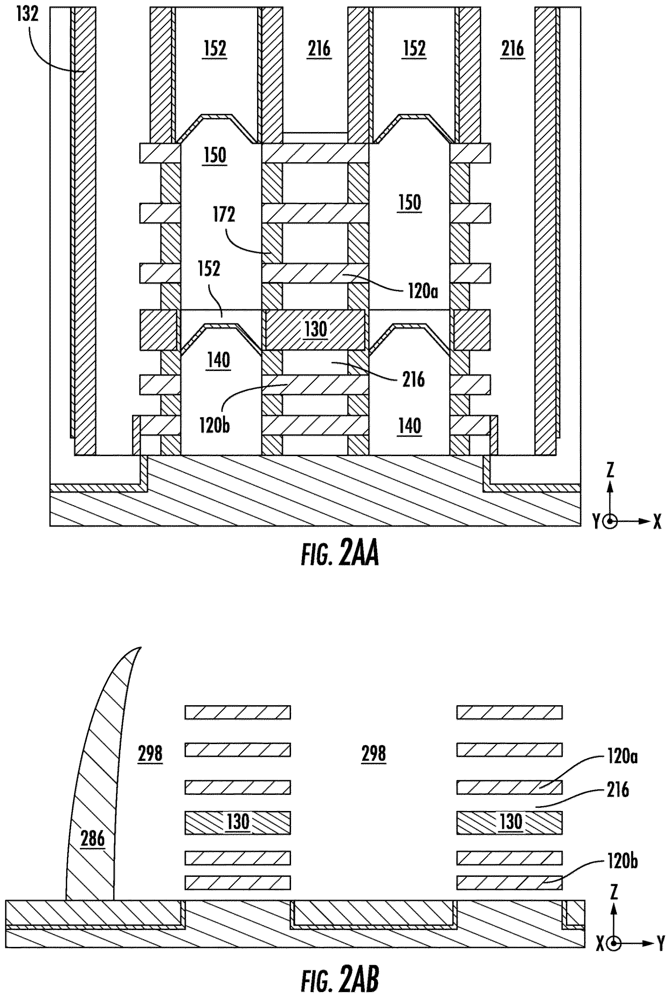

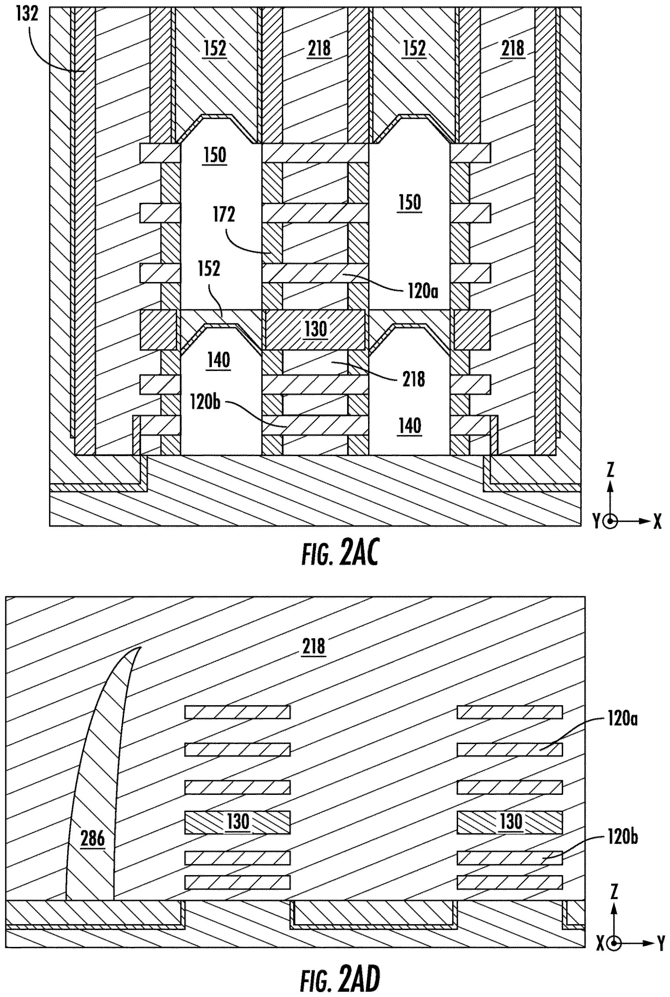

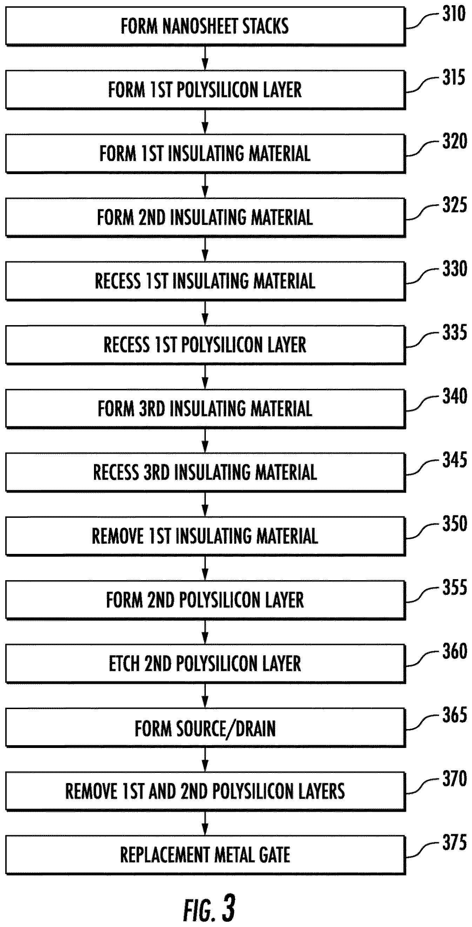

FIGs. 2A-2AD are cross-sectional views illustrating operations of forming the transistor device 100 of FIG. 1C. FIGs. 2A, 2C, 2E, 2G, 2I, 2K, 2M, 2O, 2Q, 2S, 2U, 2W, 2Y, 2AA, and 2AC are cross-sections in the X-Z plane, and FIGs. 2B, 2D, 2F, 2H, 2J, 2L, 2N, 2P, 2R, 2T, 2V, 2X, 2Z, 2AB, and 2AD are cross-sections in the Y-Z plane. FIG. 3 is a flowchart corresponding to the operations shown in FIGs. 2A-2AD.

As shown in FIGs. 2A, 2B, and 3, the operations may include forming (Block 310) stacks of semiconductor channel layers 120 on a substrate 110. In some embodiments, the channel layers 120 may be nanosheets, and the stacks may thus be nanosheet stacks. A lower stack comprises channel layers 120b, and an upper stack comprises channel layers 120a. The lower stack is separated from the upper stack by a sacrificial isolation layer 272. Moreover, sacrificial gate layers 270 may be alternately stacked on the substrate 110 with the channel layers 120. The sacrificial isolation layer 272 may be between upper ones of the sacrificial gate layers 270 and lower ones of the sacrificial gate layers 270.

The upper stack and the lower stack each form part of a transistor stack 101 (FIG. 1A). The lower channel layers 120b form part of a lower transistor Tb (FIG. 1A) of the transistor stack 101, and the upper channel layers 120a form part of an upper transistor Ta (FIG. 1A) of the transistor stack 101. Multiple transistor stacks 101 may be on the substrate 110 and spaced apart from each other in the direction Y. Accordingly, FIG. 2B shows that forming the transistor stacks 101 may include forming multiple stacks of channel layers 120 that are spaced apart from each other in the direction Y.

The channel layers 120 are semiconductor layers that comprise, for example, silicon (e.g., polysilicon). In a subsequent process/operation, the sacrificial gate layers 270 may be replaced with a metal gate 170 (FIG. 1C). Moreover, the sacrificial isolation layer 272 may be replaced with a middle dielectric isolation layer 130 (FIG. 1B) in a subsequent process/operation. The sacrificial gate layers 270 may comprise, for example, silicon germanium. Accordingly, the sacrificial gate layers 270 may have an etch selectivity relative to the channel layers 120. The sacrificial gate layers 270 may also have an etch selectivity relative to the sacrificial isolation layer 272. For example, the sacrificial isolation layer 272 and the sacrificial gate layers 270 may each comprise silicon germanium, but with different concentrations of germanium. As an example, the sacrificial isolation layer 272 may have a higher concentration of germanium (e.g., 55%) than the sacrificial gate layers 270 (e.g., 25%).

In some embodiments, an insulating layer 214 may be formed on sidewalls of the alternately-stacked channel layers 120 and sacrificial gate layers 270, and on an uppermost surface of an uppermost one of the upper channel layers 120a. Moreover, an insulating layer 112 may be formed in a recess of the substrate 110, and an insulating layer 114 may be formed in the recess on top of the insulating layer 112. The insulating layers 114, 214 may comprise the same insulating material (e.g., an oxide), and may, in some embodiments, be a single, continuous layer having no interface or separation between the insulating layers 114, 214. Moreover, the insulating material of the insulating layers 114, 214 may be different from that of the insulating layer 112, which may comprise, example, a nitride (e.g., silicon nitride).

As shown in FIGs. 2C, 2D, and 3, a semiconductor layer 274 may be formed (Block 315) on top of, and on sidewalls of, the stacks of channel layers 120. For example, the semiconductor layer 274 may be a first polysilicon layer, and may be conformally deposited on the insulating layer 214 (and on the insulating layer 114). A portion of the semiconductor layer 274 that will serve as a sacrificial spacer while forming the gate-cut 160a may be formed on a sidewall of a stack of channel layers 120 that will become part of the transistor stack 101b (FIG. 1D). In a subsequent process/operation, the semiconductor layer 274 may be replaced with a metal gate 170 (FIG. 1C).

As shown in FIGs. 2E, 2F, and 3, a first insulating material 280 may be formed (Block 320) on the semiconductor layer 274. For example, the first insulating material 280 may comprise an oxide that may fill gaps between adjacent vertical portions of the semiconductor layer 274. The oxide may then be planarized, such as by chemical-mechanical planarization (CMP), after which an uppermost surface of the first insulating material 280 may be coplanar with an uppermost surface of the first semiconductor layer 274.

As shown in FIGs. 2G, 2H, and 3, a second insulating material 282 may be formed (Block 325) on the uppermost surface of the semiconductor layer 274 and the uppermost surface of the first insulating material 280. The second insulating material 282 may be patterned to expose a portion of the uppermost surface of the semiconductor layer 274 and a portion of the uppermost surface of the first insulating material 280, while a portion of the second insulating material 282 that remains vertically overlaps the channel layers 120. Moreover, the second insulating material 282 may have an etch selectivity with respect to the first insulating material 280. For example, the second insulating material 282 may comprise a nitride, such as silicon nitride, and the first insulating material 280 may be free of nitrogen.

As shown in FIGs. 2I, 2J, and 3, the exposed portion of the first insulating material 280 may be removed (Block 330), thereby forming an opening 284 that exposes a sidewall and a lower, horizontal portion of the semiconductor layer 274. As an example, the exposed portion of the first insulating material 280 may be removed by an oxide-recess operation/process.

As shown in FIGs. 2K, 2L, and 3, the semiconductor layer 274 may be recessed (Block 335). For example, a polysilicon-recess operation/process may be performed on the exposed sidewall of the semiconductor layer 274, thereby forming a recessed sidewall 276. An upper portion of the exposed sidewall may be recessed more than a lower portion of the exposed sidewall. In some embodiments, the recessed sidewall 276 may be a sloped surface that slopes (e.g., curves) closer to the channel layers 120 with increasing vertical height. As an example, the recessed sidewall 276 may be a convex surface of the semiconductor layer 274. According to some embodiments, the second insulating material 282 may protect unexposed portions of the semiconductor layer 274 during recessing of the exposed sidewall of the semiconductor layer 274. The second insulating material 282 may be removed after forming the recessed sidewall 276 of the semiconductor layer 274.

As shown in FIGs. 2M, 2N, and 3, a third insulating material 286 may be formed (Block 340) on the recessed sidewall 276 of the semiconductor layer 274 in the opening 284, and on the uppermost surface of the semiconductor layer 274. As an example, the third insulating material 286 may be formed by conformal deposition, and thus may have a first sidewall that conforms to (and contacts) the recessed sidewall 276 of the semiconductor layer 274. Accordingly, the first sidewall of the third insulating material 286 may be a sloped surface (e.g., a concave surface) of the third insulating material 286. A second sidewall 288 of the insulating material 286 that is opposite the first sidewall may also be a sloped surface (e.g., a convex surface) of the third insulating material 286.

The third insulating material 286 may have an etch selectivity with respect to the insulating layer 114. For example, third insulating material 286 may comprise a nitride (e.g., silicon nitride), and the insulating layer 114 may comprise an oxide and/or may be free of nitrogen. In some embodiments, the third insulating material 286 may comprise the same insulating material as the second insulating material 282 (FIG. 2H).

As shown in FIGs. 2O, 2P, and 3, the third insulating material 286 may be recessed (Block 345). As a result, the uppermost surface of the semiconductor layer 274 may be exposed, and the second sidewall 288 of the third insulating material 286 may be thinned in the direction Y. For example, an upper portion of the third insulating material 286 may have a narrower width after thinning the second sidewall 288.

The third insulating material 286 having the thinned second sidewall 288 may serve as a gate-cut 160a (FIG. 1D). Accordingly, the gate-cut 160a may be formed after forming the semiconductor layer 274 (e.g., a first polysilicon layer). Moreover, forming the gate-cut 160a may include forming the third insulating material 286 on the semiconductor layer 274, which comprises a sacrificial spacer by which the gate-cut 160a is spaced apart from an adjacent stack of channel layers 120. To ensure complete separation of a subsequently-formed metal layer 218 (FIGs. 2AC, 2AD) into multiple metal gates, the gate-cut 160a extends higher (in the vertical direction Z) than an uppermost one of the upper channel layers 120a, after forming the thinned second sidewall 288.

As shown in FIGs. 2Q, 2R, and 3, the first insulating material 280 may be removed (Block 350), thereby forming openings 290 adjacent (e.g., between neighboring ones of) vertical portions of the semiconductor layer 274. For example, the first insulating material 280 may be removed by an oxide-removal operation/process. To facilitate its removal, the first insulating material 280 may have an etch selectivity relative to the third insulating material 286 and the semiconductor layer 274.

As shown in FIGs. 2S, 2T, and 3, a semiconductor layer 292 may be formed (Block 355) in the openings 284, 290 (FIGs. 2Q and 2R). For example, the semiconductor layer 292 may be a second polysilicon layer, and may be conformally deposited on the second sidewall 288 of the third insulating material 286 (e.g., on the gate-cut 160a) and on the uppermost surface of the semiconductor layer 274. In some embodiments, the semiconductor layers 274, 292 may not have an interface therebetween, as they may comprise the same semiconductor material (e.g., polysilicon). For simplicity of illustrating the formation of the semiconductor layer 292, however, an interface is shown between the semiconductor layers 274, 292 in FIGs. 2S and 2T.

As shown in FIGs. 2U, 2V, and 3, the semiconductor layers 274, 292 may be etched (Block 360). As an example, an etch mask 294 may be formed and patterned on an uppermost surface of the semiconductor layer 292, and portions of the semiconductor layers 274, 292 may be etched by reactive-ion etching (RIE) to form openings 296 that expose portions of the uppermost surface of the insulating layer 214.

As shown in FIGs. 2W, 2X, and 3, additional etching may be performed through the openings 296 to remove the exposed portions of the uppermost surface of the insulating layer 214 (FIGs. 2U and 2X), and to remove portions of the alternately-stacked channel layers 120 and sacrificial gate layers 270. The sacrificial isolation layer 272 (FIGs. 2U and 2X) may be removed and replaced with a middle dielectric isolation layer 130. Moreover, lower S/D regions 140 and upper S/D regions 150 may be formed (Block 365) on sidewalls of the alternately-stacked channel layers 120 and sacrificial gate layers 270. Accordingly, the S/D regions 140, 150 may be formed after forming the gate-cut 160a (e.g., after forming the third insulating material 286 having the thinned second sidewall 288).

In some embodiments, the S/D regions 140, 150 may be formed by epitaxial growth. For example, the lower S/D regions 140 may be epitaxially grown from the lower channel layers 120b, and the upper S/D regions 150 may be epitaxially grown from the upper channel layers 120a. According to some embodiments, the channel layers 120 may comprise silicon, and the lower S/D regions 140 and/or the upper S/D regions 150 may comprise silicon, silicon carbide, or silicon germanium.

In some embodiments, an insulating layer 132 may be formed on exposed sidewalls of the semiconductor layers 274, 292, and an insulating layer 134 may be formed on a sidewall of the insulating layer 214 at the same vertical level as the isolation layer 130. An insulating layer 152 may be formed between, in the vertical direction Z, the lower and upper S/D regions 140, 150, and on an upper surface of each of the upper S/D regions 150.

According to some embodiments, a planarization operation/process (e.g., CMP) may be performed after forming the insulating layers 132, 152. Moreover, the insulating layers 132, 134 may comprise the same insulating material (e.g., SiBCN) as the isolation layer 130, and this insulating material may be different from that of the insulating layers 152, 214 (e.g., an oxide).

In some embodiments, insulating spacers 172 may be formed on sidewalls of the sacrificial gate layers 270 and between, in the vertical direction Z, the channel layers 120. For example, the sacrificial gate layers 270 may be etched to form openings in the sacrificial gate layers 270 between the channel layers 120. Sidewalls of the sacrificial gate layers 270 may be exposed through the openings, and the spacers 172 may be formed in the openings. The spacers 172 may comprise the same insulating material (e.g., silicon nitride) as the third insulating material 286, which may be different from the insulating material of the insulating layers 152, 214, and different from the insulating material of the insulating layers 132, 134.

As shown in FIGs. 2Y, 2Z, and 3, the semiconductor layers 274, 292 (FIGs. 2W and 2X) may be removed (Block 370), thereby forming openings 298. Accordingly, a portion of the semiconductor layer 274 that serves as a sacrificial spacer between a sidewall of the third insulating material 286 and an adjacent stack of channel layers 120 may be removed after forming the S/D regions 140, 150. Moreover, the sidewall of the third insulating material 286 may be exposed through an opening 298.

As shown in FIGs. 2AA and 2AB, the sacrificial gate layers 270 may be removed from between the channel layers 120, as the sacrificial gate layers 270 may have an etch selectivity relative to the channel layers 120. Moreover, the insulating layer 214 (FIGs. 2Y and 2Z) may be removed from the tops and sidewalls of the stacks of channel layers 120, such as by an extra gate (EG) oxide removal operation/process.

As shown in FIGs. 2AC and 2AD, a metal layer 218 may be formed on the third insulating material 286 and on the stacks of channel layers 120. Though omitted from view in FIGs. 2AC and 2AD for simplicity of illustration, gate insulation layers may, according to some embodiments, be formed between the upper metal layer 218 and the channel layers 120. The operations shown in FIGS. 2AA-2AD may each be part of a replacement-metal-gate (RMG) process (Block 375 of FIG. 3) that is performed after forming the S/D regions 140, 150. Moreover, the metal layer 218 may also replace the semiconductor layer 274 (FIG. 2X) by filling spaces that were occupied by the semiconductor layer 274.

In some embodiments, the metal layer 218 may extend higher (in the vertical direction Z) than an uppermost point of the third insulating material 286. Accordingly, to ensure complete separation of the metal layer 218 into multiple metal gates, the metal layer 218 may be planarized, such as by CMP, to provide the structure shown in FIG. 1D. For example, the planarized metal layer 218 may comprise two metal gates 170a, 170b that are electrically isolated from each other by the gate-cut 160a.

According to some embodiments, the gate-cut 160a may have a flat uppermost surface after the planarization, as shown in FIG. 1D. The flat uppermost surface of the gate-cut 160a may be wider than the rounded tip portion of the third insulating material 286 that is shown in FIG. 2AD. In other embodiments, the planarization may stop at the rounded tip portion of the third insulating material 286, and the gate-cut 160a may thus have the rounded tip portion, as long as the rounded tip portion is sufficiently thick to electrically isolate the metal gate 170a from the metal gate 170b. Regardless of whether the gate-cut 160a has the flat uppermost surface or the rounded tip portion, the uppermost (e.g., narrowest) point of the gate-cut 160a may be coplanar with the uppermost surface of the each of the metal gates 170a, 170b, and thus may separate the metal gates 170a, 170b from each other.

Though FIGs. 2A-2AD illustrate operations for forming the gate-cut 160a that is shown in FIG. 1D, related operations may be used to form the gate-cut 160b shown in FIG. 1F and/or the pair of gate-cuts 160a, 160c shown in FIG. 1G. For example, the gate-cut 160b shown in FIG. 1F may be formed by forming the semiconductor layer 274 (FIG. 2D) in a U-shape between two stacks of channel layers 120, and then recessing opposing sidewalls of the U-shape to provide opposite recessed (e.g., sloped/convex) sidewalls 276 (FIG. 2L) of the semiconductor layer 274. Moreover, a lower, middle portion of the U-shape may be etched to expose the insulating layer 114 (FIG. 2D) between the sidewalls 276 (and to thereby separate the sidewalls 276 from each other). The third insulating material (layer) 286 (FIG. 2N) may then be conformally formed between the opposite recessed sidewalls 276, thereby providing the shape of the gate-cut 160b having two concave sidewalls 166a, 166b. The gate-cut 160b may be referred to herein as a "combined" gate-cut, as it may combine (i) the gate-cut 160a and (ii) a mirror image of the gate-cut 160a in a single, integrated gate-cut 160b having a wide uppermost surface 162.

Referring to FIG. 1G, the gate-cut 160c may be formed adjacent, and spaced apart from, the gate-cut 160a by modifying the operations of the FIGs. 2A-2AD to also form the semiconductor layer 274 (FIG. 2D) on a sidewall of a stack of channel layers 120 that will become part of the transistor stack 101a, and to then recess a sidewall of that portion of the semiconductor layer 274 to provide another recessed (e.g., sloped/convex) sidewall 276 of the semiconductor layer 274 that faces the recessed sidewall 276 that is shown in FIG. 2L. The third insulating material (layer) 286 (FIG. 2N) may then be conformally formed on each of the recessed sidewalls 276, thereby providing the shapes of the gate-cuts 160a, 160c that each have a concave sidewall and a convex sidewall. The gate-cuts 160a, 160c may be separated from each other by, for example, etching a portion of the third insulating material 286 that would otherwise link the gate-cuts 160a, 160c, or by forming the third insulating material 286 such that a portion thereof that becomes the gate-cut 160a is never integrated/continuous with (e.g., is separated by a vertical insulating layer from) a portion thereof that becomes the gate-cut 160c. In some embodiments, to facilitate separating the gate-cuts 160a, 160c from each other, a distance between the stack of channel layers 120 that will become part of the transistor stack 101a and the stack of channel layers 120 that will become part of the transistor stack 101b may be wider (in the direction Y) than corresponding distances in the structures shown in FIGs. 1D and 1F.

Transistor devices 100 (FIG. 1A) according to embodiments herein may provide a number of advantages. These advantages include reducing the risk of misalignment of a gate-cut 160 relative to a transistor stack 101 (FIG. 1C) by forming a semiconductor layer 274 (FIG. 2L) that serves as a sacrificial spacer for forming the gate-cut 160 before forming S/D regions 140, 150 (FIG. 2W) and before forming a metal gate 170 (FIG. 1D). The gate-cut 160 may thus be formed with a self-align technique that can help to reduce the risk of misalignment. Moreover, the self-align technique can help to reduce the total area of a stacked FET device, as stacked FET devices may otherwise (i.e., without using the self-aligned gate-cut 160) be susceptible to misalignment when down-scaling.

The semiconductor layer 274 may be formed by, for example, depositing polysilicon. A thickness of the polysilicon deposition may advantageously be more controllable than lithographic alignment. Accordingly, forming the semiconductor layer 274 before forming the gate-cut 160 can reduce the likelihood of damaging a channel layer 120 or a sacrificial gate layer 270 (FIG. 2B), in a stack that will become the transistor stack 101, when forming the gate-cut 160. Moreover, forming the gate-cut 160 using the semiconductor layer 274 as a sacrificial spacer may result in sloped (e.g., concave, convex, or diagonal) sidewalls 166a, 166b. In contrast, conventional gate-cuts may not be formed using a sacrificial semiconductor (e.g., polysilicon) spacer, may lack a convex or concave sidewall, and/or may not be adjacent a transistor stack (of a stacked FET device).

Example embodiments are described herein with reference to the accompanying drawings. Many different forms and embodiments are possible without deviating from the teachings of this disclosure and so the disclosure should not be construed as limited to the example embodiments set forth herein. Rather, these example embodiments are provided so that this disclosure will be thorough and complete, and will convey the scope of the present invention to those skilled in the art. In the drawings, the sizes and relative sizes of layers and regions may be exaggerated for clarity. Like reference numbers refer to like elements throughout.

Example embodiments are described herein with reference to cross-sectional illustrations that are schematic illustrations of idealized embodiments and intermediate structures of example embodiments. As such, variations from the shapes of the illustrations as a result, for example, of manufacturing techniques and/or tolerances, are to be expected. Thus, embodiments herein should not be construed as limited to the particular shapes illustrated herein but may include deviations in shapes that result, for example, from manufacturing.

It should also be noted that in some alternate implementations, the functions/acts noted in flowchart blocks herein may occur out of the order noted in the flowcharts. For example, two blocks shown in succession may in fact be executed substantially concurrently or the blocks may sometimes be executed in the reverse order, depending upon the functionality/acts involved. Moreover, the functionality of a given block of the flowcharts and/or block diagrams may be separated into multiple blocks and/or the functionality of two or more blocks of the flowcharts and/or block diagrams may be at least partially integrated. Finally, other blocks may be added/inserted between the blocks that are illustrated, and/or blocks/operations may be omitted without departing from the scope of the present invention.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The terminology used herein is for the purpose of describing particular embodiments only and is not intended to be limiting of the disclosure. As used herein, the singular forms "a," "an," and "the" are intended to include the plural forms as well, unless the context clearly indicates otherwise. It will be further understood that the terms "comprises," "comprising," "includes," and/or "including," when used in this specification, specify the presence of the stated features, steps, operations, elements, and/or components, but do not preclude the presence or addition of one or more other features, steps, operations, elements, components, and/or groups thereof.

It will be understood that when an element is referred to as being "coupled," "connected," or "responsive" to, or "on," another element, it can be directly coupled, connected, or responsive to, or on, the other element, or intervening elements may also be present. In contrast, when an element is referred to as being "directly coupled," "directly connected," or "directly responsive" to, or "directly on," another element, there are no intervening elements present. As used herein, the term "and/or" includes any and all combinations of one or more of the associated listed items. Moreover, the symbol "/" (e.g., when used in the term "source/drain") will be understood to be equivalent to the term "and/or."

It will be understood that although the terms "first," "second," etc. may be used herein to describe various elements, these elements should not be limited by these terms. These terms are only used to distinguish one element from another. Thus, a first element could be termed a second element without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if a device in the figures is turned over, elements described as "below" or "beneath" other elements or features would then be oriented "above" the other elements or features. Thus, the term "below" can encompass both an orientation of above and below. The device may be otherwise oriented (e.g., rotated 90 degrees or at other orientations) and the spatially relative descriptors used herein may be interpreted accordingly.

Many different embodiments have been disclosed herein, in connection with the above description and the drawings. It will be understood that it would be unduly repetitious and obfuscating to literally describe and illustrate every combination and subcombination of these embodiments. Accordingly, the present specification, including the drawings, shall be construed to constitute a complete written description of all combinations and subcombinations of the embodiments described herein, and of the manner and process of making and using them, and shall support claims to any such combination or subcombination.

## Claims

1. A transistor device (100) comprising:
a substrate (110);
a transistor stack (101) on the substrate (110), wherein the transistor stack (101) comprises a lower transistor (Tb) and an upper transistor (Ta) that is on top of the lower transistor (Tb); and
a gate-cut (160) on the substrate (110) and adjacent the transistor stack (101), wherein the gate-cut (160) comprises a first sloped sidewall (166a) and a second sloped sidewall (166b) that is opposite the first sloped sidewall (166a),
wherein an upper portion of the second sloped sidewall (166b) is adjacent the upper transistor (Ta) and slopes toward the upper transistor (Ta) as height increases.

2. The transistor device (100) of claim 1,
wherein an upper portion of the gate-cut (160) is narrower than a lower portion of the gate-cut (160), and
wherein the gate-cut (160) is asymmetrical with respect to a vertical axis (180, 182), preferably, wherein the upper portion of the gate-cut (160) comprises an uppermost point (168) that does not vertically overlap the lower portion of the gate-cut, more preferably,
wherein the uppermost point (168) is part of the second sloped sidewall (166b),
wherein the first sloped sidewall (166a) comprises an uppermost point (168) that vertically overlaps the lower portion of the gate-cut (160).

3. The transistor device (100) of claim 1 or 2,
wherein an upper portion of the gate-cut (160) is wider than a lower portion of the gate-cut (160), and
wherein the gate-cut (160) is symmetrical with respect to a vertical axis (180, 182).

4. The transistor device (100) of any one of claims 1 to 3,
wherein the gate-cut (160) is a first gate-cut (160c),
wherein the transistor device (100) further comprises a second gate-cut (160a) that is separate from the first gate-cut (160c),
wherein an upper portion of the first gate-cut (160c) is narrower than a lower portion of the first gate-cut (160c), and
wherein an upper portion of the second gate-cut (160a) is narrower than a lower portion of the second gate-cut (160a).

5. The transistor device (100) of Claim 4,
wherein at least one of:
the upper portion of the second gate-cut (160a) is spaced apart from the upper portion of the first gate-cut (160c) by a first distance (d3), and wherein the lower portion of the second gate-cut (160a) is spaced apart from the lower portion of the first gate-cut (160c) by a second distance (d2) that is shorter than the first distance (d3), and/or
the transistor stack (101) is a first transistor stack (101a), the transistor device (100) further comprises a second transistor stack (101b) on the substrate (110), and the first gate-cut (160c) and the second gate-cut (160a) are both between the first transistor stack (101a) and the second transistor stack (101b).

6. The transistor device (100) of any one of claims 1 to 4,
wherein the transistor stack (101) is a first transistor stack (101a),
wherein the transistor device (100) further comprises a second transistor stack (101b) on the substrate (110), and
wherein the gate-cut (160) is between the first transistor stack (101a) and the second transistor stack (101b).

7. The transistor device (100) of claim 5 or 6, wherein no other transistor stack is between the first transistor stack (101a) and the second transistor stack (101b).

8. The transistor device (100) of any one of claims 1 to 7,
wherein the upper transistor (Ta) comprises a plurality of semiconductor channel layers (120a),
wherein the gate-cut (160) extends higher than an uppermost one of the plurality of semiconductor channel layers (120a), and
wherein a width of the gate-cut (160) monotonically narrows from a lowermost surface (164) of the gate-cut (160) to an uppermost surface (162) of the gate-cut (160).

9. The transistor device (100) of any one of claims 1 to 8, wherein the gate-cut (160) comprises silicon nitride.

10. The transistor device (100) of any one of claims 1 to 9, wherein:
the first sloped sidewall (166a) is convex, and the second sloped sidewall (166b) is concave,
the first sloped sidewall (166a) and the second sloped sidewall (166b) are both concave, or
the first sloped sidewall (166a) is concave, and the second sloped sidewall (166b) is convex.

11. The transistor device (100) of claim 6, wherein
the first transistor stack (101a) and the second transistor stack (101b) are spaced apart from each other in a lateral direction on the substrate (110), wherein the second transistor stack (101b) comprises a lower transistor (Tb) and an upper transistor (Ta) that is on top of the lower transistor (Tb); and
the gate-cut (160) that is between, in the lateral direction, the first transistor stack (101a) and the second transistor stack (101b),
wherein each of the upper transistors (Ta) comprises a plurality of semiconductor channel layers (120a),
wherein the gate-cut (160) extends higher, in a vertical direction, than an uppermost one of the plurality of semiconductor channel layers.

12. The transistor device (100) of Claim 11,
wherein the gate-cut (160) comprises an insulating material (286), and
wherein the transistor device (100) further comprises:
a first metal gate (170a) that is on the plurality of semiconductor channel layers (120a) of the first transistor stack (101a) and on the first sidewall of the gate-cut (160); and
a second metal gate (170b) that is on the plurality of semiconductor channel layers (120a) of the second transistor stack (101b) and on the second sloped sidewall (166b) of the gate-cut (160).

13. A method of forming a transistor device (100), the method comprising:
forming a polysilicon layer (274) on a plurality of semiconductor channel layers (120a, 120b) of a transistor (Ta);
forming a gate-cut (160) after forming the polysilicon layer (274), wherein forming the gate-cut (160) comprises forming an insulating layer (286) on the polysilicon layer (274), and wherein the polysilicon layer (274) comprises a sacrificial spacer by which the gate-cut (160) is spaced apart from the plurality of semiconductor channel layers (120a, 120b); and
forming source/drain regions (140, 150) on sidewalls of the plurality of semiconductor channel layers (120a, 120b) after forming the gate-cut (160).

14. The method of Claim 13, further comprising:
removing the polysilicon layer (274) after forming the source/drain regions (140, 150); and
replacing the polysilicon layer (274) with a metal gate (218), and
preferably:
further comprising, before forming the source/drain regions (140, 150), forming another polysilicon layer (292) on the gate-cut (160),
wherein replacing the polysilicon layer (274) comprises replacing both the polysilicon layer (274) and the other polysilicon layer (292) with the metal gate (218), after forming the source/drain regions (140, 150).

15. The method of claims 13 or 14,
wherein forming the gate-cut (160) further comprises removing an upper portion of the insulating layer (286), the gate-cut (160) monotonically narrows with increased height and extends higher than an uppermost one of the plurality of semiconductor channel layers (120a, 120b), after removing the upper portion of the insulating layer (286), and wherein the transistor is an upper transistor (Ta) that is on top of a lower transistor (Tb) in a transistor stack (101); and/or
before forming the insulating layer (286), removing a portion of the polysilicon layer (274) such that the polysilicon layer (274) has a sloped sidewall (276), wherein forming the insulating layer (286) comprises conformally forming the insulating layer (286) on the sloped sidewall of the polysilicon layer.

## Amended claims

### Amended claims in accordance with Rule 137(2) EPC.

1. A transistor device (100) comprising:
a substrate (110);
a transistor stack (101) on the substrate (110), wherein the transistor stack (101) comprises a lower transistor (Tb) and an upper transistor (Ta) that is on top of the lower transistor (Tb); and
a gate-cut (160) on the substrate (110) and adjacent the transistor stack (101), wherein the gate-cut (160) comprises a first sloped sidewall (166a) and a second sloped sidewall (166b) that is opposite the first sloped sidewall (166a),
wherein an upper portion of the second sloped sidewall (166b) is adjacent the upper transistor (Ta) and slopes toward the upper transistor (Ta) as height increases,
wherein an upper portion of the gate-cut (160) is narrower than a lower portion of the gate-cut (160), and
wherein the gate-cut (160) is asymmetrical with respect to a vertical axis (180, 182), preferably, wherein the upper portion of the gate-cut (160) comprises an uppermost point (168) that does not vertically overlap the lower portion of the gate-cut, more preferably, wherein the uppermost point (168) is part of the second sloped sidewall (166b),
wherein the first sloped sidewall (166a) comprises an uppermost point (168) that vertically overlaps the lower portion of the gate-cut (160).

2. A transistor device (100) comprising:
a substrate (110);
a transistor stack (101) on the substrate (110), wherein the transistor stack (101) comprises a lower transistor (Tb) and an upper transistor (Ta) that is on top of the lower transistor (Tb); and
a gate-cut (160) on the substrate (110) and adjacent the transistor stack (101), wherein the gate-cut (160) comprises a first sloped sidewall (166a) and a second sloped sidewall (166b) that is opposite the first sloped sidewall (166a),
wherein an upper portion of the second sloped sidewall (166b) is adjacent the upper transistor (Ta) and slopes toward the upper transistor (Ta) as height increases,
wherein the gate-cut (160) is a first gate-cut (160c),
wherein the transistor device (100) further comprises a second gate-cut (160a) that is separate from the first gate-cut (160c),
wherein an upper portion of the first gate-cut (160c) is narrower than a lower portion of the first gate-cut (160c), and
wherein an upper portion of the second gate-cut (160a) is narrower than a lower portion of the second gate-cut (160a).

3. The transistor device (100) of Claim 2,
wherein at least one of:
the upper portion of the second gate-cut (160a) is spaced apart from the upper portion of the first gate-cut (160c) by a first distance (d3), and wherein the lower portion of the second gate-cut (160a) is spaced apart from the lower portion of the first gate-cut (160c) by a second distance (d2) that is shorter than the first distance (d3), and/or
the transistor stack (101) is a first transistor stack (101a), the transistor device (100) further comprises a second transistor stack (101b) on the substrate (110), and the first gate-cut (160c) and the second gate-cut (160a) are both between the first transistor stack (101a) and the second transistor stack (101b).

4. The transistor device (100) of any one of claims 1 to 3,
wherein the transistor stack (101) is a first transistor stack (101a),
wherein the transistor device (100) further comprises a second transistor stack (101b) on the substrate (110), and
wherein the gate-cut (160) is between the first transistor stack (101a) and the second transistor stack (101b).

5. The transistor device (100) of claim 3 or 4, wherein no other transistor stack is between the first transistor stack (101a) and the second transistor stack (101b).

6. A transistor device (100) comprising:
a substrate (110);
a transistor stack (101) on the substrate (110), wherein the transistor stack (101) comprises a lower transistor (Tb) and an upper transistor (Ta) that is on top of the lower transistor (Tb); and
a gate-cut (160) on the substrate (110) and adjacent the transistor stack (101), wherein the gate-cut (160) comprises a first sloped sidewall (166a) and a second sloped sidewall (166b) that is opposite the first sloped sidewall (166a),
wherein an upper portion of the second sloped sidewall (166b) is adjacent the upper transistor (Ta) and slopes toward the upper transistor (Ta) as height increases,
wherein the upper transistor (Ta) comprises a plurality of semiconductor channel layers (120a),
wherein the gate-cut (160) extends higher than an uppermost one of the plurality of semiconductor channel layers (120a), and
wherein a width of the gate-cut (160) monotonically narrows from a lowermost surface (164) of the gate-cut (160) to an uppermost surface (162) of the gate-cut (160).

7. The transistor device (100) of any one of claims 1 to 6, wherein the gate-cut (160) comprises silicon nitride.

8. A transistor device (100) comprising:
a substrate (110);
a transistor stack (101) on the substrate (110), wherein the transistor stack (101) comprises a lower transistor (Tb) and an upper transistor (Ta) that is on top of the lower transistor (Tb); and
a gate-cut (160) on the substrate (110) and adjacent the transistor stack (101), wherein the gate-cut (160) comprises a first sloped sidewall (166a) and a second sloped sidewall (166b) that is opposite the first sloped sidewall (166a),
wherein an upper portion of the second sloped sidewall (166b) is adjacent the upper transistor (Ta) and slopes toward the upper transistor (Ta) as height increases,
wherein:
the first sloped sidewall (166a) is convex, and the second sloped sidewall (166b) is concave,
the first sloped sidewall (166a) and the second sloped sidewall (166b) are both concave, or
the first sloped sidewall (166a) is concave, and the second sloped sidewall (166b) is convex.

9. The transistor device (100) of claim 8, wherein
the first transistor stack (101a) and the second transistor stack (101b) are spaced apart from each other in a lateral direction on the substrate (110), wherein the second transistor stack (101b) comprises a lower transistor (Tb) and an upper transistor (Ta) that is on top of the lower transistor (Tb); and
the gate-cut (160) that is between, in the lateral direction, the first transistor stack (101a) and the second transistor stack (101b),
wherein each of the upper transistors (Ta) comprises a plurality of semiconductor channel layers (120a),
wherein the gate-cut (160) extends higher, in a vertical direction, than an uppermost one of the plurality of semiconductor channel layers.

10. The transistor device (100) of Claim 9,
wherein the gate-cut (160) comprises an insulating material (286), and
wherein the transistor device (100) further comprises:
a first metal gate (170a) that is on the plurality of semiconductor channel layers (120a) of the first transistor stack (101a) and on the first sidewall of the gate-cut (160); and
a second metal gate (170b) that is on the plurality of semiconductor channel layers (120a) of the second transistor stack (101b) and on the second sloped sidewall (166b) of the gate-cut (160).

11. A method of forming a transistor device (100) according to any one of claims 1 to 10, the method comprising:
forming a polysilicon layer (274) on a plurality of semiconductor channel layers (120a, 120b) of a transistor (Ta);
forming a gate-cut (160) after forming the polysilicon layer (274), wherein forming the gate-cut (160) comprises forming an insulating layer (286) on the polysilicon layer (274), and wherein the polysilicon layer (274) comprises a sacrificial spacer by which the gate-cut (160) is spaced apart from the plurality of semiconductor channel layers (120a, 120b); and
forming source/drain regions (140, 150) on sidewalls of the plurality of semiconductor channel layers (120a, 120b) after forming the gate-cut (160).

12. The method of Claim 11, further comprising:
removing the polysilicon layer (274) after forming the source/drain regions (140, 150); and
replacing the polysilicon layer (274) with a metal gate (218), and
preferably:
further comprising, before forming the source/drain regions (140, 150), forming another polysilicon layer (292) on the gate-cut (160),
wherein replacing the polysilicon layer (274) comprises replacing both the polysilicon layer (274) and the other polysilicon layer (292) with the metal gate (218), after forming the source/drain regions (140, 150).

13. The method of claims 11 or 12,
wherein forming the gate-cut (160) further comprises removing an upper portion of the insulating layer (286), the gate-cut (160) monotonically narrows with increased height and extends higher than an uppermost one of the plurality of semiconductor channel layers (120a, 120b), after removing the upper portion of the insulating layer (286), and wherein the transistor is an upper transistor (Ta) that is on top of a lower transistor (Tb) in a transistor stack (101); and/or
before forming the insulating layer (286), removing a portion of the polysilicon layer (274) such that the polysilicon layer (274) has a sloped sidewall (276), wherein forming the insulating layer (286) comprises conformally forming the insulating layer (286) on the sloped sidewall of the polysilicon layer.
